(19) Europäisches Patentamt
European Patent Office
Office européen des brevets

(11) Publication number: **0 416 012 B1**

# (12) EUROPEAN PATENT SPECIFICATION

(45) Date of publication of patent specification: **24.11.93**

(51) Int. Cl.[5]: **C09K 13/08**

(21) Application number: **89906541.1**

(22) Date of filing: **05.05.89**

(86) International application number:
**PCT/US89/01869**

(87) International publication number:
**WO 89/11517 (30.11.89 89/28)**

## (54) ETCHING SOLUTIONS CONTAINING ANIONIC SULFATE ESTERS OF ALKYLPHENOL POLYGLYCIDOL ETHERS.

(30) Priority: **16.05.88 US 194256**
**16.05.88 US 194621**

(43) Date of publication of application:
**13.03.91 Bulletin 91/11**

(45) Publication of the grant of the patent:
**24.11.93 Bulletin 93/47**

(84) Designated Contracting States:
**BE CH DE FR GB IT LI NL**

(56) References cited:
**EP-A- 0 115 583**
**SU-A- 0 773 063**
**US-A- 3 181 984**
**US-A- 3 992 235**
**US-A- 4 582 624**
**US-A- 4 761 245**
**FR-A- 2 393 840**
**US-A- 2 213 477**
**US-A- 3 725 080**
**US-A- 4 517 106**
**US-A- 4 620 934**

**"Glycidol Surfactant 10G Specialty Nonionic Surfactant", publ. 1979 by Olin Chemicals (Connecticut), see entire document**

(73) Proprietor: **OLIN CORPORATION**
**350 Knotter Drive**
**P.O. Box 586**
**Cheshire, CT 06410-0586(US)**

(72) Inventor: **SCARDERA, Michael**
**81 Manor Street**
**Hamden, CT 06517(US)**
Inventor: **ROCHE, Thomas, S.**
**8602 East Cheryl Drive**
**Scottsdale, Arizona 85258(US)**

(74) Representative: **Klunker . Schmitt-Nilson . Hirsch**
**Winzererstrasse 106**
**D-80797 München (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

EP 0 416 012 B1

"Fluorad; Fluorchemical Surfactants", publ. 1982 by 3M Corporation (Minnesota), see entire document

Chemical Abstracts, vol. 99 issued 1983 (Columbus, Ohio, USA), Daikin Kogyo Col, "Etching Composition", see page 624, column 2, abstract no. 97788t, Jpn. Appl. 81/152,413, 25. Sept. 1981

## Description

This invention relates to etching solutions used in the manufacture of integrated circuits. More particularly this invention relates to etching solutions containing wetting agents to properly wet substrates of components in the manufacture of integrated circuits.

As integrated circuit component dimensions decrease, physical wetting by etchant solutions on substrate surfaces becomes more difficult. This is especially important for buffered oxide etchants i.e., ammonium fluoride/hydrofluoric acid solutions used in silicon dioxide etching as these solutions exhibit extremely high surface tension values at typical etching temperatures. Because of the relatively low surface energies of the masking materials used and the photoresist topography, it is difficult to properly wet the substrate, which results in non-uniform etching and poor line reproduction.

While pretreatment ("predipping") of the component into a surfactant solution before placing the substrates in the etching solution is known, more satisfactory results are obtained by the addition of the wetting agent to the etching solution. However, most surfactants commonly used in the industry are insoluble in buffered oxide etchant solutions containing ammonium fluoride and hydrofluoric acid. Further, sufficient amounts of the wetting agent must remain in the etching solution after filtration through filters on the order of 0.2µm (microns) to provide the desired wetting of the substrates during the etching process.

Wetting agents containing fluorochemical compounds have been employed as additives to $NH_4F/HF$ etching solutions to improve wetting properties. Examples of fluorochemical compounds include perfluorinated alkyl sulfonates described in U.S. Patent No. 4,517,106, issued May 14, 1985, and fluorinated cycloalkane and cycloalkene sulfonates taught in U.S. Patent No. 4,620,934, issued November 4, 1986 to R. J. Hopkins et al; fluorine-containing carboxylic acids described in U.S. Patent No. 4,582,624, issued April 15, 1986 to N. Enjo et al; and fluorine-containing diamine compounds as described in Japanese Patent Kokai Publication No. 53,980/1983 published March 30, 1983 by Daikin Kogyo KK. Some of these wetting agents are readily removed during filtration through sub-micron filters; others have low solubility in the etching solutions; and in addition, these wetting agents are expensive to use.

There is a need for wetting agents which are readily soluble in buffered etching solutions containing ammonium fluoride, which retain their solubility and wetting characteristics after repeated filtrations through sub-micron filters and in addition, provide excellent wetting properties at reduced costs.

It is an object of the present invention to provide etching solutions for use in integrated circuit manufacture having excellent wetting characteristics which are retained during filtration through sub-micron filters.

Another object of the present invention is to provide buffered etching solutions containing ammonium fluoride and hydrogen fluoride having excellent wetting characteristics for components having small and large geometries.

A further object of the present invention is to provide a process for etching silicon dioxide substrates having desirable etching rates.

These and additional objects of the present invention are accomplished in an etching solution comprising an aqueous solution of ammonium fluoride and from 5 to 50,000 parts per million by weight of a sulfate ester of an alkylphenol polyglycidol ether or an alkyl amine glycidol adduct.

The process for etching a silicon dioxide coated substrate comprises immersing the substrate in an aqueous etching solution comprised of ammonium fluoride and from 5 to 50,000 parts per million by weight of a sulfate ester of an alkylphenol polyglycidol ether or an alkyl amine glycidol adduct.

The glycidol compounds which are useful as wetting agents include the sulfate esters of alkylphenol polyglycidol ethers having an alkyl substituted phenol adduct with any suitable number of glycidol groups and at least 0.1 moles of sulfate ester or a water-soluble sulfate salt.

Suitable anionic sulfate esters of alkylphenol polyglycidol ethers may be represented by the formula:

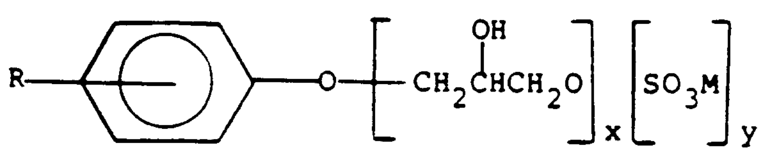

(I)

wherein R represents an alkyl group having from 4 to 12 carbon atoms, x is from 3 to 15, M represents H, an alkali metal, an alkaline earth metal, ammonium, or an amine, and y is from 0.2 to 4.

The alkylphenol polyglycidol ether sulfate esters which are useful as wetting agents in the etching solutions of this invention having the above formula include those in which R represents alkyl groups

including, for example, butyl, hexyl, octyl, nonyl, and dodecyl. Preferred embodiments include those in which R represents an alkyl group having from 8 to 12 carbon atoms and these include octyl, nonyl, and dodecyl groups. The polyglycidol ether groups represented by x are preferably in the range of from 6 to 12. It should be noted that x represents an average number of glycidol units per alkylphenol unit. The sulfate group may be in the free acid ester form in which case M represents H, or a water-soluble salt thereof where M represents an alkali metal, an alkaline earth metal, ammonium, or an amine. Suitable salts include those in which M represents sodium or potassium, ammonium, calcium or magnesium or an amine such as ethanolamine, diethanolamine, triethanolamine, methylamine, dimethylamine, trimethylamine, ethylamine, triethylamine, diethylamine, butylamine, propylamine, cyclohexylamine, morpholine, pyridine, octanolamine, octylamine, and the like.

Preferred embodiments of the wetting agent used in the etching compositions of the present invention are those in which R represents an alkyl group having from 8 to 12 carbon atoms; M represents an alkali metal such as Na or K, ammonium ($NH_4$) or an amine; and y is from 1 to 3.

More preferred embodiments for etching compositions to be used in etching small geometries are those free of mobile ions and M is ammonium, and R represents an alkyl group located primarily in the para position. These wetting agents do not incorporate metallic ions which may be present during the etching process.

Anionic alkylphenol polyglycidol ether sulfate esters of the above type can be produced using processes such as those described in U.S. Patent Nos. 2,213,477 and 2,233,281 to produce the alkylphenol polyglycidol ethers followed by the esterification method, for example, described in U.S. Patent Nos. 2,758,977 or 3,725,080.

Alkyl amine glycidol adducts which are useful as wetting agents in the etching solutions of the present invention include those having a primary or secondary alkyl amine group and any suitable number of glycidol groups. Suitable alkyl amines include homogeneous amine groups as well as mixtures such as those sold commercially as coco amines, soya amines, and tallow amines or mixed fatty amines.

Preferred embodiments of the nonionic alkyl amine glycidol adducts employed in the eching solution of the present invention are those represented by the formulas:

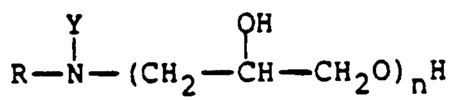

(I)

wherein

R represents an alkyl group having from 8 to 18 carbon atoms and mixtures thereof,

Y represents H,

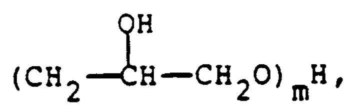

or mixtures thereof;

n is from 1 to 20; and

m + n are from 2 to 20;

or

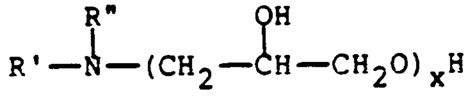

(II)

wherein

R' and R'' represent independently selected alkyl groups, the sum total of carbon atoms in R' + R'' being from 8 to 18; and

x is from 1 to 20.

Amine glycidol adducts represented by the above formulas include those of Formula I in which R represents as alkyl groups, for example, octyl, nonyl, decyl, hendecyl, dodecyl or coco or lauryl, tetradecyl,

pentadecyl, hexadecyl, heptadecyl, octadecyl or stearyl or tallow or soya, and mixtures thereof. The adducts are generally a mixture in which Y represents both H and the glycidol group and the amine is therefore a mixture of secondary and tertiary amine mixture. Preferred embodiments of the amine glycidol adducts represented by Formula I are those in which Y represents

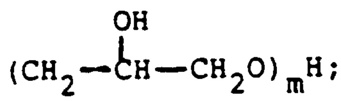

and m + n are from 2 to 16.

Amine glycidol adducts represented by Formula II include those, for example, in which R' represents butyl, hexyl, octyl, nonyl, decyl or coco, hendecyl, dodecyl or lauryl or coco, tetradecyl, pentadecyl, hexadecyl, or heptadecyl, and R'' represents, for example, methyl, ethyl, butyl, hexyl, or octyl.

x in Formula II is preferably from 2 to 16.

More preferred embodiments of the amine glycidol adducts include those in which R represents an alkyl group having from 12 to 16 carbon atoms and mixtures thereof; and m + n are from about 2 to about 10. It is noted that the m, n or x represent an average number of glycidol units per alkyl amine unit. The nonionic amine glycidol adducts used as wetting agents can be prepared, for example, by the method described in U.S. Patent No. 2,089,569, published August 10, 1937 by L. Orthner and C. Heuck.

These liquid wetting agents are employed in an amount of from 5 to 50,000, parts per million by weight which, in the buffered oxide etching solutions, will enhance the wetting of the substrate to be etched. Preferred wetting amounts are in the range of from about 25 to about 30,000, parts per million by weight and more preferably from about 50 to about 5,000 parts per million.

The novel etching solutions of the present invention, as buffered oxide etchants, are aqueous solutions of ammonium fluoride having a concentration of between 15 percent and 40 percent by weight of $NH_4F$. Admixed with the ammonium fluoride is an aqueous solution of hydrogen fluoride in amounts which provide the buffered oxide etchant with at least 3 parts by volume of $NH_4F$ to 1 part by volume of HF and up to 100 parts by volume of $NH_4F$ to 1 part by volume of HF. In preparing the buffered oxide etching solutions of the present invention, commercially available concentrated aqueous solutions of $NH_4F$ (normally about 40 percent by weight) and HF (normally about 49 percent by weight) may be employed.

Other acids could be used in place of hydrogen fluoride in the ammonium fluoride etching solutions of the present invention including, for example, hydrogen chloride, acetic acid, nitric acid, fluoboric acid, and the like.

The novel etching solution of the present invention may be prepared in any suitable manner. For example, an aqueous solution of ammonium fluoride and the wetting agent may be prepared and the hydrogen fluoride then added; the aqueous solutions of ammonium fluoride and hydrogen fluoride and the nonionic wetting agent may be simultaneously blended or the aqueous mixture of ammonium fluoride and hydrogen fluoride prepared and the wetting agent then blended in.

The novel etching solutions of the present invention all retain their wetting properties after 0.2 $\mu$m (micron] filtration, even under continuous filtration conditions. Moreover, the etching solutions after filtering have the property of wetting substrates more effectively and yield more uniform results by etching small geometries (1 to 5$\mu$m (microns)) and large geometries (>5$\mu$m (micron)) of silicon dioxide in a patterned resist at the same rate without additional deleterious effects. Further, the nonionic wetting agents do not incorporate metallic ions in their structure.

Other additives normally used in buffered oxide etchant solutions may be included in the novel etching solutions of the present invention. For example, polar solvent diluents such as acetic acid, ethylene glycols, glycerol, and lower alkyl alcohols having from 1 to 4 carbon atoms may be included.

The etching solutions are used to etch silicon dioxide coated substrates in the manufacture of integrated circuits employing methods and procedures known in the semiconductor industry.

The novel etching solutions of the present invention provide etchant solutions with reduced surface tensions after microfiltration which improves substrate wetting and yields superior etchant performance resulting in cleaner surfaces and greater uniformity of etched profiles without incorporating foreign metallic ions. The solutions are stable and have desirable shelf lives without phase separations of the wetting agent from the $NH_4F$ and HF components.

The following examples illustrate the present invention with no intention of being limited thereby.

EXAMPLE 1

Preparation of the Sulfate Ester (1) of Nonylphenol Polyglycidol (10) Ether*

In a reactor fitted with a thermometer, a magnetic stirrer, and an $N_2$ gas inlet, was placed 130 g (.13 mole) nonylphenol polyglycidol (10) ether. The flask was heated to 123°C and 13.0 g (.13 m) sulfamic acid was added. After an initial temperature drop, the temperature quickly rose, reaching a peak of 153°C, then fell back to 125°C. The product mixture was stirred and heated for an additional 40 minutes. After cooling to 55°C, 40 ml ethanol, 36 ml water, and 4 ml 30 percent $H_2O_2$ were added. The temperature was increased to 70°C and heated an additional hour with stirring. An additional 6 ml water was then added, the reaction mixture cooled to ambient temperature, and the product collected. The product, a 1.0 m sulfate ester of nonylphenol polyglycidol (10) weighed 222 g and was obtained as a 65 percent active solution.

EXAMPLE 2

Preparation of Sulfate (1.5) Ester of Nonylphenol Polyglycidol (10) Ether

In a reactor of the type used in EXAMPLE 1 was placed 137 g (.14 mole) nonylphenol polyglycidol (10) ether. The flask was heated to 125°C and 6.86 g sulfamic acid is added. After stirring and allowing the reaction temperature to return to 125°C from the resulting exotherm, an additional 6.86 g of sulfamic acid was added. The procedure was repeated with an additional 6.86 g sulfamic acid so that a total of 20.6 g (.21 mole) sulfamic acid was reacted. The reaction mixture was stirred at 120° to 125°C for two hours. The temperature was then reduced by cooling to 70°C and 42 ml ethanol, 5 ml $H_2O_2$ and 43 ml water added. After stirring for an additional hour, the product was collected. The product, 1.5 m sulfate ester of nonylphenol polyglycidol (10) was obtained as a 65 percent active solution and weighed 240 g.

EXAMPLES 3-4

Using the procedure of EXAMPLE 1, the sulfate ester (1) of nonylphenol polyglycidol (6) ether and the sulfate ester (3) of nonylphenol polyglycidol (10) ether were prepared.

EXAMPLE 5

A buffered oxide etching aqueous solution was prepared containing 7 parts by volume of 40 percent ammonium fluoride and 1 part by volume of 49 percent hydrogen fluoride. To 800 ml of the etching solution was added 250 parts per million of the nonylphenol polyglycidol sulfate (1) ester containing about 10 glycidol units as prepared in EXAMPLE 1 as the wetting agent. The surface tension of the etching solution was measured with a Du Nouy Ring Tensiometer at 25°C. The solution was continuously filtered through a 0.2µm(micron) polytetrafluoroethylene filter (Millipore) at a rate of 13.33 ml/s (800 ml/min) for 5 to 5-1/2 hours and the surface tension measured again. The results are shown in TABLE I below.

EXAMPLES 6-8

The procedure described in EXAMPLE 5 was followed exactly using the wetting agents prepared in EXAMPLES 2, 3, and 4 respectively. The results are shown in TABLE I below.

(*Olin Glycidol Surfactant 10G, a product of Olin Corporation.)

TABLE I

| Example No. | Wetting Agent | Surface Tension (10⁻³ N/m) ((dynes/cm)) Before Filtration | After Filtration |
|---|---|---|---|
| 5 | Nonylphenol polyglycidol (10) sulfate (1) ester | 32.4 | 35.9 |
| 6 | Nonylphenol polyglycidol (10) sulfate (1.5) ester | 34.0 | 34.0 |
| 7 | Nonylphenol polyglycidol (6) sulfate (1) ester | 30.0 | 32.7 |
| 8 | Nonylphenol polyglycidol (10) sulfate (3) ester | 35.3 | 38.7 |

EXAMPLES 5-8 show that the loss in wetting activity after continuous filtration over an extended period of time is negligible.

EXAMPLES 9-12

101.6 mm (Four inch) silicon wafers were oxidized thermally to about 6000 Å (determined by ellipsometry) coated with positive photoresist to a thickness of about 1.2µm (microns), and patterned with masks having geometries of about 1.6 to about 2µm (microns). The etch time was then calculated. One wafer was immersed in the buffered oxidized etching solution of EXAMPLE 5. The etching, at 25°C, was conducted until the 100 percent etch time, as calculated, was attained. The etched pattern was then rinsed in water. The wafer was then inspected with a light microscope with a magnification in the range of 400X to 1000X. This procedure was repeated with the buffered oxide etching solutions of EXAMPLES 6, 7, and 8.

Comparative Examples A, B, and C

The procedure of EXAMPLES 9-12 was repeated exactly with three 101.6mm (4-inch] silicon wafers. The patterned wafers were immersed in a buffered oxide etching solution (volume ratio 7:1 of $NH_4F$:HF) which contained no wetting agent for etch times of 100 percent, 105 percent, and 110 percent. The etched wafers were then rinsed in water and inspected using the procedure of EXAMPLES 9-12. The results are given in TABLE II below.

TABLE II

| Example No. | % of Etch Time | 2 µm (Micron) | 1.8 µm (Micron) | 1.6 µm (Micron) |
|---|---|---|---|---|
| 9 | 100 | 100 | 100 | 100 |
| 10 | 100 | 100 | 100 | 100 |
| 11 | 100 | 100 | 100 | 100 |
| 12 | 100 | 100 | 100 | 100 |
| Comparative A | 100 | 63 | 51 | 42 |
| Comparative B | 105 | 98 | 95 | 89 |
| Comparative C | 110 | 100 | 100 | 98 |

The results in TABLE II illustrate that the etching solutions of the present invention (EXAMPLES 9-12) etch small geometries completely with the desired etch time without requiring overetching which results in the loss of pattern definition.

EXAMPLE 13

Preparation of Hexadecylamine Glycidol (5) Adduct

Into a reactor fitted with a dropping funnel, a $N_2$ gas inlet, a stirrer, a thermometer, a condenser, and a gas vent, was placed 36 g (0.15 mole) of hexadecylamine. Under a nitrogen atmosphere, glycidol (55.5 g, 0.75 mole) was added dropwise to the hexadecylamine at 150° to 160°C. Upon completion of the addition, the reaction mixture was stirred at 150° to 160°C for an additional 45 minutes. The reaction mixture was cooled and the product removed from the flask. The product, identified as a hexadecylamine adduct with 5 moles of glycidol, weighed 91 grams.

EXAMPLE 14

Using the process of EXAMPLE 13, the hexadecylamine adduct with 12 moles of glycidol was prepared.

EXAMPLE 15

Preparation of Cocoamine Glycidol (3) Adduct

Into a reactor of the type used in EXAMPLE 13 was placed 92.5 g (0.5 m) of cocoamine*. Under a nitrogen atmosphere, glycidol (111 g, 1.5 m) was added dropwise to the cocoamine at 150° to 170°C. After complete addition of the glycidol and post-reaction, 101.75 g of a product was removed and identified as an adduct of cocoamine and 3 m of glycidol.

EXAMPLE 16

To 101.25 g (0.25 m of the 3:1 adduct) of the reaction mixture remaining in the reactor of EXAMPLE 15 was added 37 g (0.5 m) of glycidol dropwise at 160°C. Upon completion of the glycidol addition and post-reaction, this product was cooled to room temperature. The product weighed 138.2 g and was identified as an adduct of cocoamine with 6 moles of glycidol.

EXAMPLES 17-18

Using the process of EXAMPLES 15 and 16, the cocoamine adducts with 2 moles of glycidol and with 5 moles of glycidol were prepared.

EXAMPLE 19

Using the process of EXAMPLE 13, dodecylamine (Armeen 12D, a product of Akzo Chemie America) was reacted with glycidol to produce the dodecylamine adduct of 6 moles of glycidol.

EXAMPLE 20

A buffered oxide etching aqueous solution was prepared containing 7 parts by volume of 40 percent ammonium fluoride and 1 part by volume of 49 percent hydrogen fluoride. To 800 ml of the etching solution was added 250 parts per million of the hexadecylamine glycidol (5) adduct prepared in EXAMPLE 13.

The surface tension of the etching solution was measured with a Du Nouy Ring Tensiometer at 25°C. The solution was continuously filtered through a 0.2µm (micron) polytetrafluoroethylene filter (Millipore) at a rate of 13.33 ml/s (800 ml/min) for 5 to 5-1/2 hours and the surface tension measured again. The results are shown in TABLE III below.

(*Armeen C, a product of Akzo Chemie America.)

EXAMPLES 21-24

The procedure of EXAMPLE 20 was repeated exactly with the substitution for the hexadecylamine glycidol (5) adduct of the following wetting agents.

EXAMPLE 21 Hexadecylamine Glycidol (prepared in (12) Adduct EXAMPLE 2)
EXAMPLE 22 Cocoamine Glycidol (2) (prepared in Adduct EXAMPLE 5)
EXAMPLE 23 Cocoamine Glycidol (5) (prepared in Adduct EXAMPLE 6)
EXAMPLE 24 Dodecylamine Glycidol (prepared in (6) Adduct EXAMPLE 7)

The results are given in TABLE III below.

TABLE III

| | | Surface Tension ((dynes/cm)) ($\frac{10^{-3}N}{m}$) | |
|---|---|---|---|
| Example No. | Wetting Agent | Before Filtration | After Filtration |
| 20 | Hexadecylamine Glycidol (5) Adduct | 39.2 | 40.7 |
| 21 | Hexadecylamine Glycidol (12) Adduct | 39.4 | 44.0 |
| 22 | Cocoamine Glycidol (2) Adduct | 34.2 | 36.5 |
| 23 | Cocoamine Glycidol (5) Adduct | 37.5 | 40.5 |
| 24 | Dodecylamine Glycidol (6) Adduct | 38.0 | 37.8 |

TABLE III shows that the etching solutions of EXAMPLES 20-24 of the present invention have only a small loss in wetting activity after continuous filtration over an extended period of time.

EXAMPLES 25-26

101.6mm (Four inch) silicon wafers were oxidized thermally to about 6000 Å, (determined by ellipsometry) coated with positive photoresist to a thickness of about 1.2µm(microns), and patterned with masks having geometries of about 1.6, about 1.8 and about 2µm(microns). The etch time was then calculated. One wafer was immersed in the buffered oxide etching solution of EXAMPLE 13. The etching, at 25°C, was conducted until the 100 percent etch time, as calculated, was attained. The etched pattern was then rinsed in water. The wafer was then inspected with a light microscope with a magnification in the range of 400X to 1000X. This procedure was repeated exactly with the buffered oxide etching solution of EXAMPLE 14. The results are given in TABLE IV below.

Comparative Examples D, E, and F

The procedure of EXAMPLE 25 was repeated exactly with three 101.6mm (4-inch) silicon wafers. The patterned wafers were immersed in a buffered oxide etching solution (volume ratio 7:1 of $NH_4F$:HF) which contained no wetting agent for etch times of 100 percent, 105 percent, and 110 percent. The etched wafers were then rinsed in water and inspected using the procedure of EXAMPLE 15. The results are given in

TABLE IV below.

TABLE IV

| Percent of Completely Etched Geomotries | | | | |
|---|---|---|---|---|
| Example No. | % of Etch Time | 2 µm (Micron] | 1.8 µm (Micron) | 1.6 µm (Micron) |
| 25 Hexadecylamine Glycidol (5) Adduct | 100 | 100 | 100 | 100 |
| 26 Dodecylamine Glycidol (6) Adduct | 100 | 100 | 100 | 100 |
| Comparative D | 100 | 63 | 51 | 42 |
| Comparative E | 105 | 98 | 95 | 89 |
| Comparative F | 110 | 100 | 100 | 98 |

EXAMPLES 25-26 illustrate that the etching solutions of the present invention etch small geometries completely within the desired etch time without requiring overetching which results in the loss of pattern definition.

## Claims

1. An etching solution comprising an aqueous solution of ammonium fluoride and from 5 to 50,000 parts per million by weight of a sulfate ester of an alkylphenol polyglycidol ether or an alkyl amine glycidol adduct.

2. The etching solution of claim 1 in which the ammonium fluoride is present in concentrations of from 15 to 40 percent by weight.

3. The etching solution of claim 1 in which hydrogen fluoride is present and the volume ratio of $NH_4F$ to HF is from 3:1 to 100:1.

4. The etching solution of claim 1 in which the sulfate ester of an alkylphenyl polyglycidol ether is represented by the formula:

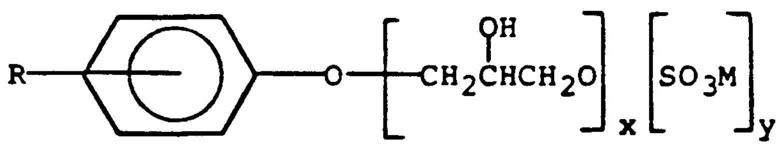

(I)

wherein R represents an alkyl group having from 4 to 12 carbon atoms, x is from 3 to 15, M represents H, an alkali metal, an alkaline earth metal, ammonium, or an amine, and y is from 0.2 to 4.

5. The etching solution of claim 1 containing at least 0.1 moles of sulfate ester or a water soluble sulfate salt.

6. The etching solution of claim 5 in which M represents an alkali metal, ammonium, or an amine.

7. The etching solution of claim 5 in which R represents an alkyl group having from 8 to 12 carbon atoms.

8. The etching solution of claim 7 in which X is from 6 to 12.

9. The etching solution of claim 8 in which y is from 1 to 3.

10. The etching solution of claim 9 in which M represents ammonium.

11. The etching solution of claim 7 in which R represents an alkyl group which is primarily in the para position.

**12.** The etching solution of claim 11 in which R represents the nonyl group.

**13.** The etching solution of claim 1 in which the alkyl amine is a secondary amine, a tertiary amine or mixtures thereof.

**14.** The etching solution of claim 1 in which the amine glycidol adduct is represented by the formulas:

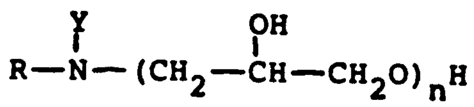

(I)

wherein

R represents an alkyl group having from 8 to 18 carbon atoms and mixtures thereof,

Y represents H,

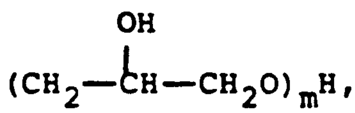

or mixtures thereof;

n is from 1 to 20; and

m + n are from 2 to 20;

or

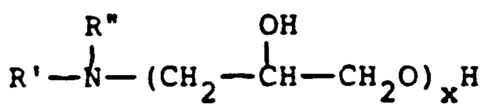

(II)

wherein

R' and R'' represent independently selected alkyl groups, the sum total of carbon atoms in R' + R'' being from 8 to 18; and

x is from 1 to 20.

**15.** The etching solution of claim 14 in which the nonionic amine glycidol adduct is represented by the formula:

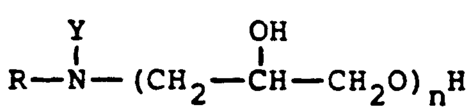

in which R represents an alkyl group having from 12 to 16 carbon atoms and mixtures thereof.

**16.** The etching solution of claims 15 in which m + n are from 2 to 16.

**17.** The etching solution of claim 16 in which R represents cocoamine.

**18.** The etching solution of claim 14 in which the nonionic amine glycidol adduct is represented by the formula:

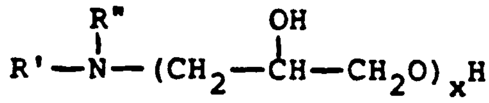

in which x is from 2 to 16.

**19.** The etching solution of claim 18 in which R'' represents, for example, methyl, ethyl, or butyl.

**20.** A process for etching a silicon dioxide coated substrate which comprises immersing the substrate in an aqueous etching solution comprised of ammonium fluoride and from 5 to 50,000 parts per million by weight of a sulfate ester of an alkylphenol polyglycidol ether or an alkyl amine glycidol adduct.

**21.** The process of claim 20 in which the sulfate ester of an alkylphenyl polyglycidol ether is represented by the formula:

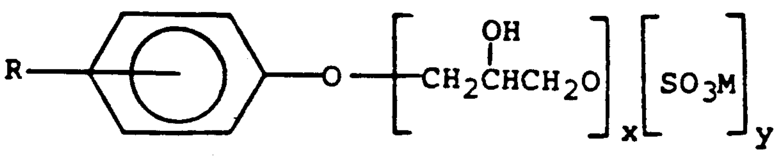 (I)

wherein R represents an alkyl group having from 4 to 12 carbon atoms, x is from 3 to 15, M represents H, an alkali metal, an alkaline earth metal, ammonium, or an amine, and y is from 0.2 to 4.

**22.** The process of claim 20 in which the amine glycidol adduct is represented by the formulas:

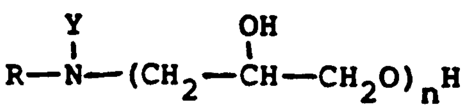 (I)

wherein

R represents an alkyl group having from 8 to 18 carbon atoms and mixtures thereof,

Y represents H,

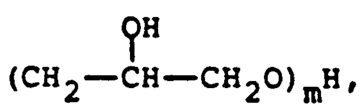

or mixtures thereof;

n is from 1 to 20; and

m + n are from 2 to 20;

or

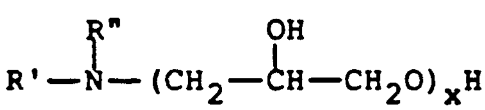 (II)

wherein

R' and R'' represent independently selected alkyl groups, the sum total of carbon atoms in R' + R'' being from 8 to 18; and

x is from 1 to 20.

**Patentansprüche**

1. Ätzlösung aufweisend eine wässrige Lösung von Ammoniumfluorid und 5 bis 50.000 Gewichtsteilen pro Million eines Sulfatesters eines Alkylphenolpolyglycidolethers oder eines Alkylaminglycidol-Addukts.

2. Ätzlösung nach Anspruch 1, bei der das Ammoniumfluorid in Konzentrationen von 15 bis 40 Gew.- % anwesend ist.

3. Ätzlösung nach Anspruch 1, bei der Fluorwasserstoff anwesend ist und das Volumenverhältnis von $NH_4F$ zu HF 3:1 bis 100:1 beträgt.

4. Ätzlösung nach Anspruch 1, bei der der Sulfatester eines Alkylphenylpolyglycidolethers dargestellt wird durch die Formel:

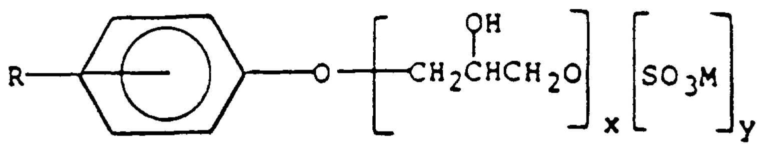

(I)

in der R eine Alkylgruppe mit 4 bis 12 Kohlenstoffatomen darstellt, x 3 bis 15 ist, M H, ein Alkalimetall, ein Erdalkalimetall, Ammonium oder ein Amin darstellt und y 0,2 bis 4 ist.

5. Ätzlösung nach Anspruch 1, die mindestens 0,1 Mole eines Sulfatesters oder eines wasserlöslichen Sulfatsalzes enthält.

6. Ätzlösung nach Anspruch 5, bei der M ein Alkalimetall, Ammonium oder ein Amin darstellt.

7. Ätzlösung nach Anspruch 5, bei der R eine Alkylgruppe mit 8 bis 12 Kohlenstoffatomen darstellt.

8. Ätzlösung nach Anspruch 7, bei der x 6 bis 12 ist.

9. Ätzlösung nach Anspruch 8, bei der y 1 bis 3 ist.

10. Ätzlösung nach Anspruch 9, bei der M Ammonium darstellt.

11. Ätzlösung nach Anspruch 7, bei der R eine Alkylgruppe darstellt, die primär in der para-Stellung ist.

12. Ätzlösung nach Anspruch 11, bei der R die Nonylgruppe darstellt.

13. Ätzlösung nach Anspruch 1, bei der das Alkylamin ein sekundäres Amin, ein tertiäres Amin oder Mischungen davon ist.

14. Ätzlösung nach Anspruch 1, bei der das Aminglycidol-Addukt dargestellt wird durch die Formeln:

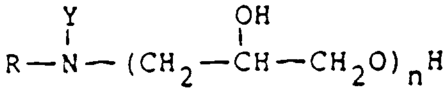

(I)

in der R eine Alkylgruppe mit 8 bis 18 Kohlenstoffatomen und Mischungen davon darstellt;
Y H,

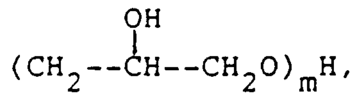

oder
Mischungen davon darstellt;
n von 1 bis 20 beträgt; und
m + n von 2 bis 20 betragen;
oder

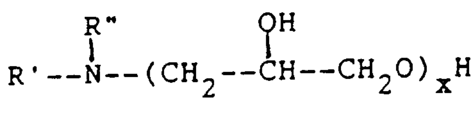 (II)

in der R' und R'' unabhängig voneinander ausgewählte Alkylgruppen darstellen, wobei die Gesamtsumme der Kohlenstoffatome in R' + R'' 8 bis 18 beträgt; und x 1 bis 20 beträgt.

**15.** Ätzlösung nach Anspruch 14, bei der das nichtionische Aminglycidol-Addukt dargestellt wird durch die Formel:

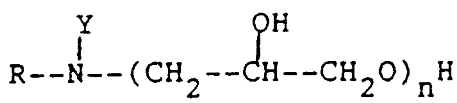

in der R eine Alkylgruppe mit 12 bis 16 Kohlenstoffatomen und Mischungen davon darstellt.

**16.** Ätzlösung nach Anspruch 15, bei der m + n 2 bis 16 sind.

**17.** Ätzlösung nach Anspruch 16, bei der R Kokosamin darstellt.

**18.** Ätzlösung nach Anspruch 14, bei der das nichtionische Aminglycidol-Addukt dargestellt wird durch die Formel:

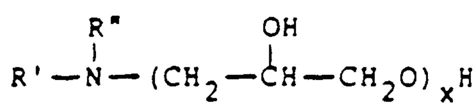

in der x 2 bis 16 beträgt.

**19.** Ätzlösung nach Anspruch 18, bei der R'' zum Beispiel Methyl, Ethyl oder Butyl darstellt.

**20.** Verfahren zum Ätzen eines siliciumdioxidbeschichteten Substrats, aufweisend das Eintauchen des Substrats in eine wässrige Ätzlösung, die zusammengesetzt ist aus Ammoniumfluorid und 5 bis 50.000 Gewichtsteilen pro Million eines Sulfatesters eines Alkylphenolpolyglicidolethers oder eines Alkylaminglycidol-Addukts.

**21.** Verfahren nach Anspruch 20, bei dem der Sulfatester eines Alkylphenylpolyglycidolethers dargestellt wird durch die Formel:

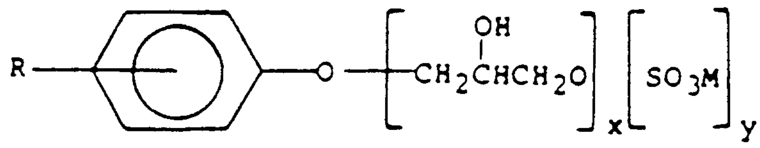

(I)

in der R eine Alkylgruppe mit 4 bis 12 Kohlenstoffatomen darstellt, x 3 bis 15 ist, M H, ein Alkalimetall, ein Erdalkalimetall, Ammonium oder ein Amin darstellt, und y 0,2 bis 4 ist.

**22.** Verfahren nach Anspruch 20, bei dem das Aminglycidol-Addukt dargestellt wird durch die Formeln:

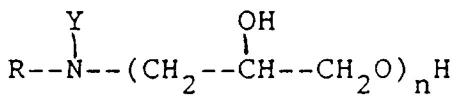

(I)

in der R eine Alkylgruppe mit 8 bis 18 Kohlenstoffenatomen und Mischungen davon darstellt,
Y H,

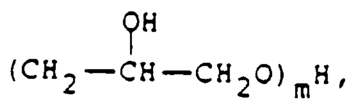

, oder
Mischungen davon darstellt;
n 1 bis 20 ist; und
m + n 2 bis 20 sind;
oder

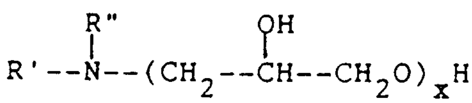

(II)

in der R' und R'' unabhängig voneinander ausgewählte Alkylgruppen darstellen, wobei die Gesamtsumme an Kohlenstoffatomen in R' + R'' 8 bis 18 beträgt; und x 1 bis 20 ist.

## Revendications

**1.** Solution de gravure comprenant une solution aqueuse de fluorure d'ammonium et de 5 à 50 000 parties par million en poids d'un ester de sulfate d'un éther d'alkylphénol de polyglycidol ou d'un produit d'addition alkylamine-glycidol.

**2.** Solution de gravure selon la revendication 1, dans laquelle le fluorure d'ammonium est présent en concentrations de 15 à 40 pourcent en poids.

**3.** Solution de gravure selon la revendication 1, dans laquelle le fluorure d'hydrogène est présent et le rapport volumique de $NH_4F$ à HF est de 3:1 à 100:1.

**4.** Solution de gravure selon la revendication 1, dans laquelle l'ester de sulfate d'un éther d'alkylphénol de polyglycidol est représenté par la formule:

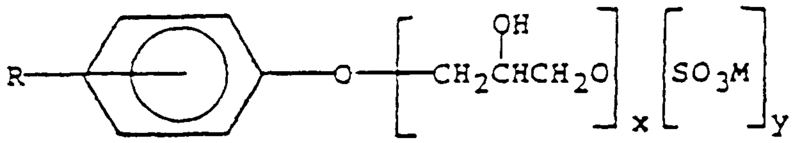

(I)

dans laquelle R représente un groupe alkyle ayant 4 à 12 atomes de carbone, x vaut de 3 à 15, M représente H, un métal alcalin, un métal alcalino-terreux, un ammonium, ou une amine, et y vaut de 0,2 à 4.

**5.** Solution de gravure selon la revendication 1, contenant au moins 0,1 mole d'ester de sulfate ou un sel de sulfate hydrosoluble.

**6.** Solution de gravure selon la revendication 5, dans laquelle M représente un métal alcalin, un ammonium ou une amine.

**7.** Solution de gravure selon la revendication 5, dans laquelle R représente un groupe alkyle ayant de 8 à 12 atomes de carbone.

**8.** Solution de gravure selon la revendication 7, dans laquelle x vaut de 6 à 12.

**9.** Solution de gravure selon la revendication 8, dans laquelle y vaut de 1 à 3.

**10.** Solution de gravure selon la revendication 9, dans laquelle M représente un ammonium.

**11.** Solution de gravure selon la revendication 7, dans laquelle R représente un groupe alkyle qui est principalement dans la position para.

**12.** Solution de gravure selon la revendication 11, dans laquelle R représente le groupe nonyle.

**13.** Solution de gravure selon la revendication 1, dans laquelle l'alkylamine est une amine secondaire, une amine tertiaire ou un de ses mélanges.

**14.** Solution de gravure selon la revendication 1, dans laquelle le produit d'addition amine-glycidol est représenté par les formules:

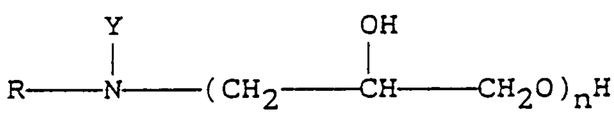

(I)

dans laquelle
R représente un groupe alkyle ayant de 8 à 18 atomes de carbone et leurs mélanges,
Y représente H,

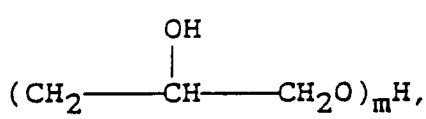

ou leurs mélanges;
n vaut de 1 à 20; et
m + n vaut de 2 à 20;
ou bien

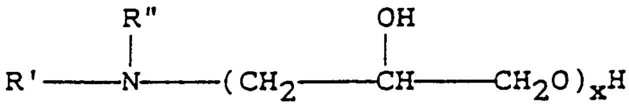 (II)

dans laquelle
R'et R" représentent des groupe alkyle choisis indépendamment, la somme totale d'atomes de carbone dans R' + R" valant de 8 à 18; et
x vaut de 1 à 20.

**15.** Solution de gravure selon la revendication 14, dans laquelle le produit d'addition amine-glycidol non ionique est représenté par la formule:

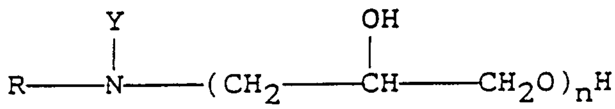

dans laquelle
R représente un groupe alkyle ayant de 12 à 16 atomes de carbone et leurs mélanges.

**16.** Solution de gravure selon la revendication 15, dans laquelle m + n vaut de 2 à 16.

**17.** Solution de gravure selon la revendication 16, dans laquelle R représente une amine de coprah.

**18.** Solution de gravure selon la revendication 14, dans laquelle le produit d'addition amine-glycidol non ionique est représenté par la formule:

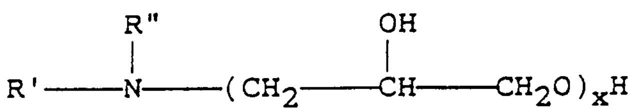

dans laquelle x vaut de 2 à 16.

**19.** Solution de gravure selon la revendication 18, dans laquelle R" représente, par exemple, le groupe méthyle, éthyle, ou butyle.

**20.** Procédé pour graver un substrat revêtu de dioxyde de silicium qui comprend l'immersion du substrat dans une solution aqueuse de gravure comprenant du fluorure d'ammonium et de 5 à 50 000 parties par million en poids d'un ester de sulfate d'un éther d'alkylphénol de polyglycidol ou un produit d'addition alkylamine-glycidol.

**21.** Procédé selon la revendication 20, dans lequel l'ester de sulfate d'un éther d'alkylphénol de polyglycidol est représenté par la formule:

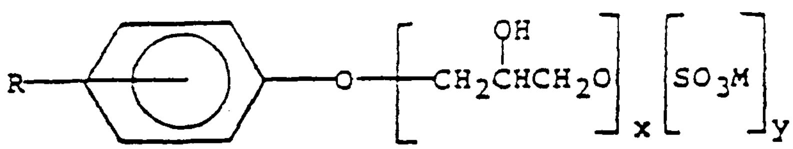 (I)

dans laquelle R représente un groupe alkyle ayant de 4 à 12 atomes de carbone, x vaut de 3 à 15, M représente H, un métal alcalin, un métal alcalino-terreux, un ammonium, ou une amine, et y vaut de 0,2 à 4.

**22.** Procédé selon la revendication 20, dans lequel le produit d'addition amine-glycidol est représenté par les formules:

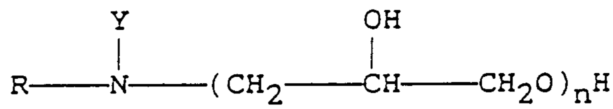

(I)

dans laquelle
R représente un groupe alkyle ayant 8 à 18 atomes de carbone et leurs mélanges,
Y représente H,

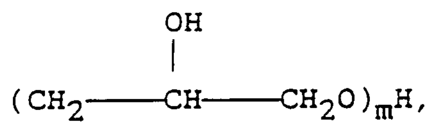

ou leurs mélanges;
n vaut de 1 à 20; et
m + n vaut de 2 à 20;
ou bien

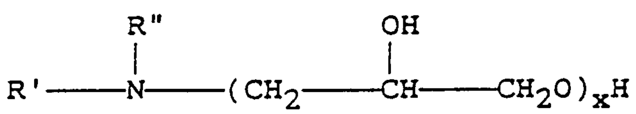

(II)

dans laquelle
R' et R'' représentent des groupes alkyle choisis indépendamment, la somme totale d'atomes de carbone dans R' + R'' valant de 8 à 18; et
x vaut de 1 à 20.